# EUROPEAN PATENT APPLICATION

(11) **EP 4 712 257 A1**
(43) Date of publication of application: **18.03.2026**
(21) Application number: 24386110.1
(22) Date of filing: 13.09.2024
(51) Int. Cl.: H01P 1/18, H01P 3/00

(54) **CONTROLLING IMPEDANCE AND PHASE SHIFT OF A TRANSMISSION LINE**

(71) Applicant: NXP B.V., 5656 AG Eindhoven (NL)
(72) Inventor: Pijl-Peeters, Jasper, Austin, TX 78735 (US); Yang, Xin, Austin, TX 78735 (US); Acar, Mustafa, Austin, TX 78735 (US); Giannakidis, Konstantinos, Austin, TX 78735 (US)
(74) Representative: Hardingham, Christopher Mark

(57) **Abstract**

An electronic component includes a transmission structure and a shield structure below the transmission structure. The transmission structure includes a central trace and a pair of lateral traces. The shield structure includes multiple switchable shield elements that extend below the central trace. At least one of the shield elements is selectively electrically connectable to a lateral shield trace, causing the component to assume multiple values of characteristic impedance and phase shift. An associated device and a method of operation are further disclosed.

## Description

### TECHNICAL FIELD:

This disclosure is directed generally to transmission lines, and more particularly to transmission lines having adjustable characteristic impedance and phase shift.

### BACKGROUND

Transmission lines are common structures found in many RF (radio frequency) and microwave applications. A typical transmission line may include a central trace and a pair of lateral traces that run parallel to the central trace, one lateral trace on each side of the central trace. The central trace and the lateral traces are coplanar and may be realized on a single layer of a printed circuit board, hybrid module, or semiconductor device, for example. Transmission lines having this design are sometimes referred to as "coplanar waveguides."

The central trace carries a signal, and the lateral traces provide shielding. The lateral traces are typically grounded. A first end of the central trace provides an input of the transmission line, and a second end opposite the first end provides an output. Between the input and the output, the transmission line manifests a particular characteristic impedance and a particular phase shift, which are based on its geometrical characteristics, e.g., lengths and widths of the traces and spacing between them.

In some examples, additional shielding may be provided above or below the transmission line. For example, a ground plane may be provided on a layer below the transmission line. The ground plane increases the capacitance and decreases the inductance of the transmission line, thus altering its characteristic impedance and phase shift, which is equivalent to propagation delay. As another example, distinct grounded traces, also known as cross-ties, may be provided in place of a ground plane. The cross-ties run perpendicularly to the traces of the transmission line and provide slow-wave shielding. The number, width, and spacing of the cross-ties affects the characteristic impedance and phase shift of the transmission line.

### BRIEF DESCRIPTION OF THE SEVERAL VIEWS OF THE DRAWINGS

The foregoing and other features and advantages will be apparent from the following description of particular embodiments, as illustrated in the accompanying drawings, in which like reference characters refer to the same or similar parts throughout the different views. The drawings are not necessarily to scale, emphasis instead being placed upon illustrating the principles of various embodiments.
FIG. 1 is a top plan view of an example transmission structure that forms a portion of an electronic component with which one or more embodiments of the improved technique can be practiced.
FIG. 2 is a top plan view of an example shield structure that forms another portion of the electronic component with switches shown schematically, according to one or more embodiments.
FIG. 3 is a simplified isometric view of the electronic component formed using the transmission structure of FIG. 1 and the shield structure of FIG. 2 according to one or more embodiments.
FIGS. 4a-4c are top plan views of the example shield structure of FIG. 2 in which switches are shown schematically in various switch configurations for achieving respective values of characteristic impedance and phase shift, according to one or more embodiments.
FIG. 5 is a top plan view of the example shield structure of FIG. 2 in which first and second shunt switches for first and second shield elements have respective resistances that differ from each other, according to one or more embodiments.
FIG. 6 is a scatter plot of phase shift versus characteristic impedance of the electronic component according to one or more embodiments, based on varying only shunt switches with all series switches left open.
FIG. 7 is a scatter plot of phase shift versus characteristic impedance of the electronic component according to one or more embodiments, based on varying only series switches with all shunt switches left closed.
FIG. 8 is a scatter plot of phase shift versus characteristic impedance of the electronic component according to one or more embodiments, based on varying both shunt switches and series switches.
FIG. 9 is a block diagram of example control circuitry suitable for operating the electronic component, according to one or more embodiments.
FIG. 10 is a block diagram of an example arrangement for varying switch settings of the component to change an electrical characteristic, according to one or more embodiments.
FIG. 11 is a cross-sectional view of a semiconductor die or a portion thereof in which an example electronic component is formed according to one or more embodiments, taken from the perspective of line A-A of FIG. 3.
FIG 12 is a cross-sectional view of the semiconductor die or portion thereof of FIG. 11, taken from the perspective of line B-B of FIG. 3.
FIG. 13 is an isometric view of an example semiconductor device that includes the die of FIGS. 11 and 12, according to one or more embodiments.
FIG. 14 is an isometric view of an example electronic component that includes a transmission structure with two shield structures, one disposed above the transmission structure and another disposed below the transmission structure.
FIG. 15 is a flowchart showing an example method of operating an electronic component according to one or more embodiments.

### DETAILED DESCRIPTION

Prior implementations of transmission lines have characteristics that are fixed by design or that provide limited adjustability. For example, once a transmission line has been built with a particular geometry, the characteristic impedance and phase shift of the transmission line are fixed and cannot readily be changed. Designs that use slow-wave cross-ties sometimes enable certain cross-ties to connect to ground or to disconnect from ground, thus varying characteristics. But the degree of adjustability is typically limited to a small number of discrete settings. What is needed, therefore, is a transmission line that provides a wider range of adjustability in both characteristic impedance and phase shift.

The above need is addressed at least in part by an improved technique that provides an electronic component. The component includes a transmission structure and a shield structure below the transmission structure. The transmission structure includes a central trace and a pair of lateral traces that extend parallel to the central trace, with one lateral trace on each side of the central trace. The central trace is electrically isolated from the lateral traces, e.g., using air gaps and/or electrically insulating material. The shield structure includes a pair of lateral traces that extend below and parallel to the lateral traces of the transmission structure and multiple shield elements that extend in a line below the central trace and between the lateral traces of the shield structure. The component further includes multiple shunt switches configured to selectively electrically connect one or more of the shield elements to one or both lateral traces of the shield structure. With the shunt switches all opened, the shield elements are electrically isolated from the lateral traces of the shield structure. Advantageously, different configurations of the shunt switches result in different characteristic impedances of the component and different phase shifts through the component.

In some examples, the component further includes multiple series switches configured to selectively electrically connect particular adjacent shield elements to each other. With the series switches and shunt switches all opened, the shield elements are electrically isolated from each other, e.g., using air gaps and/or electrically insulating material. Different configurations of the series switches result in different characteristic impedances of the component and different phase shifts through the component. In addition, embodiments that include combinations of both shunt switches and series switches opens a large design space of characteristic impedance and phase shift, which is greater than would be possible if only shunt switches or only series switches were used. Also, configurations (e.g., switch states) of the shunt and/or series switches can be changed dynamically in an operating circuit, to vary the behavior of the circuit in real time.

Embodiments of the improved technique will now be described. One should appreciate that such embodiments are provided by way of example to illustrate certain features and principles but are not intended to be limiting.

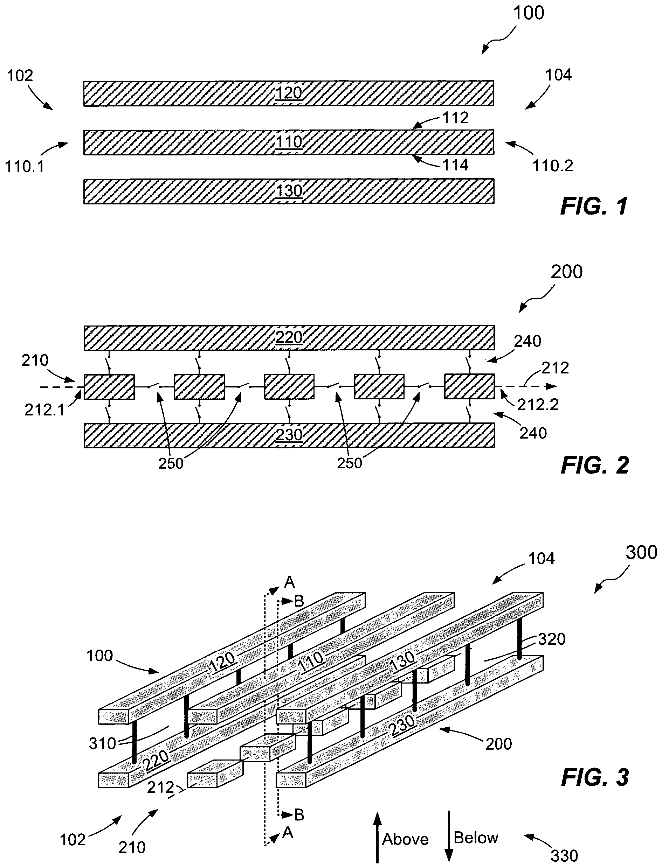

FIG. 1 shows a top plan view of an example transmission structure 100 that forms part of an electronic component according to one or more embodiments. The transmission structure 100 includes a first conductive trace 110, a second conductive trace 120, and a third conductive trace 130, all running in parallel. A "trace" as used herein refers to an electrically conductive feature, such as a portion of a patterned conductive layer of a semiconductor device or printed circuit board. The second conductive trace 120 is spaced apart from a first side 112 of the first trace 110, and the third conductive trace 130 is spaced apart from a second side 114 of the first trace 110. The first, second, and third conductive traces preferably have the same or similar lengths. The lengths of the depicted traces 110, 120, and 130 are short for ease of illustration. One should appreciate, though, that the traces may be arbitrarily long. In an example, the transmission structure 100 takes the form of a coplanar waveguide. However, embodiments are not limited to coplanar waveguides and may include transmission lines of other types.

The first conductive trace 110 may also be referred to herein as a "central" trace, and the second and third conductive traces 120 and 130 may also be referred to herein as "lateral" traces. The first conductive trace 110 extends from a proximal end 110.1 to a distal end 110.2. In some examples, the proximal end 110.1 provides a signal input 102 of the component and the distal end 110.2 provides a signal output 104. Both the input 102 and the output 104 are relative to the lateral traces 120 and 130, which are typically grounded.

Preferably, the first conductive trace 110, second conductive trace 120, and third conductive trace 130 are coplanar and may be formed on a first layer of a device or assembly, such as in a first metallization layer of a semiconductor device, a first layer of a printed circuit board, a first layer of a ceramic substrate, or the like. Some embodiments may provide the first conductive trace 110 on a higher or lower level than the second and third conductive traces 120 and 130, however. Preferably, both the area between the first conductive trace 110 and the second conductive trace 120 and the area between the first conductive trace 110 and the third conductive trace 130 are devoid of metal material.

FIG. 2 shows a top plan view of an example shield structure 200 of the electronic component according to one or more embodiments. The shield structure 200 may be disposed directly below the transmission structure 100 (from a particular frame of reference), and includes a fourth conductive trace 220, a fifth conductive trace 230, and a plurality of spaced-apart, conductive shield elements 210. The shield elements 210 extend in a line 212 that extends between the fourth conductive trace 220 and the fifth conductive trace 230. The line 212 is parallel to and spaced apart from the fourth conductive trace 220 and the fifth conductive trace 230. Although five shield elements 210 are shown, one should appreciate that any number of shield elements 210 may be provided, from just two to tens or even hundreds, as applications require and technological constraints allow. The fourth conductive trace 220 and the fifth conductive trace 230 may also be referred to herein as "lateral" traces of the shield structure 200.

The shield structure 200 is arranged such that the fourth conductive trace 220 extends directly below and parallel to the second conductive trace 120 and the fifth conductive trace 230 extends directly below and parallel to the third conductive trace 130. Also, the shield elements 210 extend directly below the first conductive trace 110, from a first location 212.1 normally disposed directly below the proximal end 110.1 of the first conductive trace 110 and a second location 212.2 normally disposed directly below the distal end 110.2 of the first conductive trace 110. There is no requirement, though, that the first location 212.1 coincide precisely with the proximal end 110.1 or that the second location 212.2 coincide precisely with the distal end 110.2.

In an example, the fourth conductive trace 220, fifth conductive trace 230, and shield elements 210 are coplanar and are formed on a second layer of the above-described device or assembly, such as a second metallization layer of a semiconductor device, a second layer of a printed circuit board, a second layer of a ceramic substrate, or the like. In such an example, the first and second layers of the above-described device or assembly are physically and electrically separated by one or more layers of electrically insulating material. In other examples, the fourth conductive trace 220, fifth conductive trace 230, and shield elements 210 are not coplanar. For example, the shield elements 210 may be formed on a lower or higher level than the traces 220 and 230, which may be formed on the same layer. Also, different shield elements 210 may be formed on different layers.

One should appreciate that the terms "first layer," "second layer," and the like merely serve as identifiers and are not intended to denote any particular sequence. For example, the device or assembly may include other metal layers above or below the "first layer" and one or more additional metal layers may be included between the first layer and the second layer. In some examples, such additional metal layers are preferably devoid of metal material in the space between the transmission structure 100 and the shield structure 200. In some examples, the selection of metal layers on which to place the transmission structure 100 and shield structure 200 is based on electrical characteristics, such as desired capacitance and inductance and the dielectric constant of the insulating material that separates the metallization layers.

FIG. 2 further shows various switches, which include "shunt" switches 240 and "series" switches 250. The switches 240 and 250 are shown schematically, as they typically are not formed on the same layer or layers as the shield structure 200 but rather are formed elsewhere in the device or assembly, such as in a semiconductor substrate or with discrete components. The shunt switches 240 are arranged to selectively electrically couple respective shield elements 210 to the lateral traces 220 and 230, and the series switches 250 are arranged to selectively electrically couple adjacent shield elements 210 to each other. Although two shunt switches (upper and lower) are shown for each shield element 210, one or more embodiments may include only a single shunt switch (upper or lower) per shield element 210. The shield elements 210 may also be referred to herein as "switchable shield elements," as they are capable of being connected via switches 240 and 250 to the lateral traces 220 and 230 and/or to adjacent shield elements 210. Also, the terms "shunt" and "series" are used herein merely to distinguish the two groups of switches 240 and 250. Other connotations of the words "shunt" and "series" are not intended.

Preferably, the switches 240 and 250 are implemented using single transistors, such as single MOSFETs (metal-oxide-semiconductor field-effect transistors) or BJTs (bipolar junction transistors), or using PIN (positive-intrinsic-negative) diodes. SOI (silicon-on-insulator) technology is particularly suitable for high-frequency signals (tens or hundreds of gigahertz, as may be conveyed along trace 110), given the low insertion loss and wide bandwidth that this technology can achieve. Other options include MEMS (micro electro-mechanical systems) switches and PCM (phase change material) RF switches.

Although FIG. 2 does not explicitly show control inputs to the switches 240 and 250, one should appreciate that each switch preferably has a control input. The control input has an open condition (e.g., voltage or current) that causes the switch to open, forming a high-resistance path between the contacts, and a closed condition that causes the switch to close, forming a low-resistance path between the contacts. With transistors, a control terminal provides the control input, and current-carrying terminals provide the contacts. For instance, the gate terminal of a FET (field-effect transistor) provides the control input and the drain and source terminals provide the contacts. With BJTs, the base terminal provides the control input and the collector and emitter terminals provide the contacts. In typical operation, the lateral traces 220 and 230 are grounded (i.e., electrically connected to a ground reference terminal, which in turn, may be connected to a system ground reference). Also, the shield elements 210 are electrically floating when all switches are opened, and the shield elements 210 are grounded when the switches provide a path to grounded traces 220 and/or 230. In this context, the drain and source of a FET, or the collector and emitter of a BJT, can be connected in either direction.

Preferably, control circuitry operates the depicted switches 240 and 250 individually, i.e., the shunt switches 240 and series switches 250 are individually controllable for opening and closing independently of one another. However, some implementations may operate certain switches together (e.g., synchronously). For example, upper and lower shunt switches 240 for a particular shield element 210 may be operated together, e.g., responsive to a single control signal from the control circuitry.

FIG. 3 provides a three-dimensional view of an example of the above-described electronic component, labeled here with reference numeral 300. As shown, the component 300 includes the transmission structure 100 (FIG. 1) and the shield structure 200 (FIG. 2). Switches 240 and 250 are omitted from FIG. 3 for the sake of clarity, but it is to be understood that switches 240 and/or 250 would be included in component 300. The shield structure 200 is disposed below the transmission structure 100 in the manner described above, i.e., with lateral traces 220 and 230 running below and parallel to the lateral traces 120 and 130, respectively, and with shield elements 210 extending in a line 212 below the central trace 110. In the example shown, the lateral traces 220 and 230 are coplanar with the shield elements 210, which are coplanar with one another.

As further shown in FIG. 3, multiple conductive paths 310 electrically connect the lateral trace 120 of the transmission structure 100 to the lateral trace 220 of the shield structure 200. Likewise, multiple conductive paths 320 electrically connect the lateral trace 130 of the transmission structure 100 to the lateral trace 230 of the shield structure 200. The conductive paths 310 and 320 may be realized using conductive vias or other vertical conduction structures, for example, which extend through the insulating layer(s) between the lateral traces 120, 130, 220, 230. Although not shown, additional electrical connections may be formed between the lateral traces 120 and 130 and/or between the lateral traces 220 and 230, ensuring that all lateral traces 120, 130, 220, and 230 are at the same potential, which is typically ground when the component 300 is integrated into a larger electrical system. One should appreciate, though, that a given circuit or system may include multiple grounds, and that the component 300 may be referenced to other potentials besides ground.

A legend 330 at the bottom right of FIG. 3 depicts a convention used herein for distinguishing vertical positions of elements. The terms "above" and "below," along with similar terms, designate relative vertical positions from the frame of reference shown in legend 330. The terms do not necessarily correspond to terrestrial notions of "above" and "below" or "up" and "down," however. Thus, a first feature may be identified herein as "below" or "beneath" a second feature even though the second feature appears to be above the first feature from a particular observer's point of view.

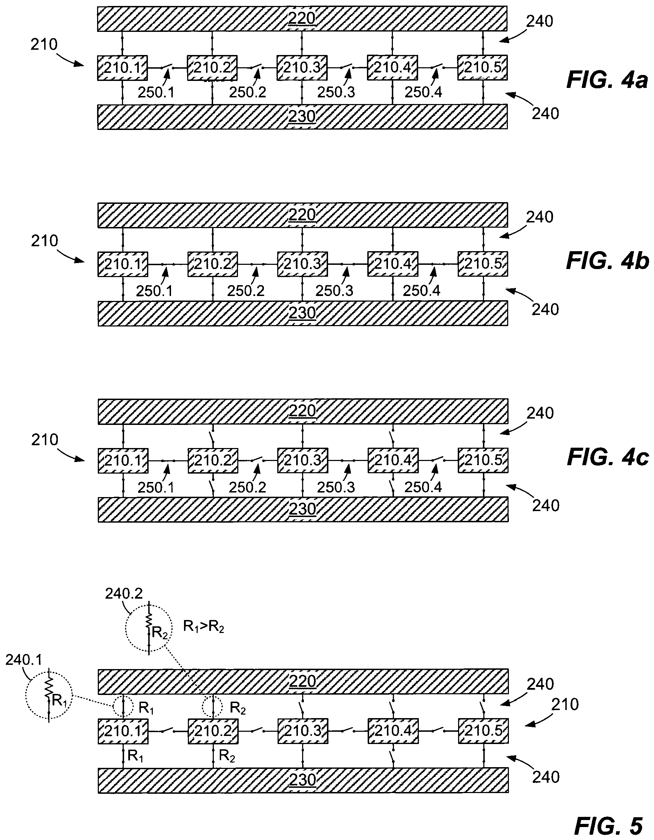

FIGS. 4a through 4c show various examples of switch settings that may be realized for the shunt switches 240 and series switches 250 of FIG. 2. Here, individual shield elements 210.1 through 210.5 and individual series switches 250.1 through 250.4 are shown. In FIG. 4A, all shunt switches 240 are closed and all series switches 250.1 through 250.4 are opened. This switch configuration causes the component 300 to assume the highest achievable capacitance and inductance along the signal path from input 102 to the output 104 (FIG. 1), resulting in large phase shifts compared with other switch configurations. In FIG. 4B, all switches are closed, resulting in high capacitance and low inductance and therefore low characteristic impedance compared with other switch configurations. In FIG. 4C, an alternating arrangement is applied, where shunt switches 240 of every other shield element 210 are closed, and every other series switch 250 is closed. This arrangement provides intermediate levels of capacitance and inductance. Given the 14 switches illustrated, a total of 2¹⁴ unique switch configurations is possible.

FIG. 5 shows another example arrangement of switches. Here, different shunt switches 240 may be provided via paths having different series resistances. For example, a path through switch 240.1 has series resistance R₁ and a path through switch 240.2 has series resistance R₂, where R₁ is greater than R₂. Different resistances may be realized, for example, using different resistor components or by using transistors (or other switches) having different intrinsic resistances, such as switches having different sizes. As another example, different resistances may be established by varying the degree to which transistors are turned on. For example, a transistor may assume low resistance by turning the transistor more fully on and may assume a higher resistance by turning the transistor less fully on, e.g., by operating the transistor in its linear range. Regardless of how different resistances are achieved, the ability to provide different resistances in different switches provides an additional source of variability in characteristics that the component 300 may assume. Although only shunt switches 240 are shown as having different resistances, further variability can be achieved by providing series switches 250 with different resistances. In some examples, the switches 240 and/or 250 may have not only resistive components to their impedance but also reactive components, which may be varied in different switches by using different capacitors or by using varactors, for example.

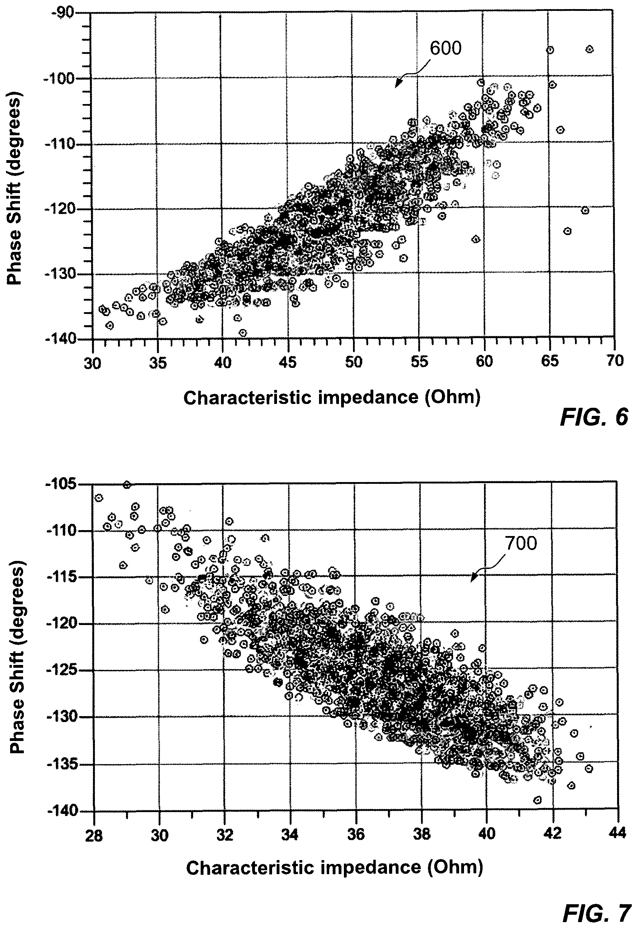

FIGS. 6, 7, and 8 show example plots that result from simulating a component 300 having a total of 44 switches, including 30 shunt switches 240 and 14 series switches 250. For these examples, a single control bit controls the two shunt switches 240 for each shield element 210 , resulting in a total of 29 control bits (15 for the 30 shunt switches and 14 for the 14 series switches). The 29 control bits give a total of 2²⁹ possible switch configurations for the component 300. As simulating all 2²⁹ scenarios is not computationally practical, each plot is generated using Monte-Carlo sampling. Open switches are modeled as one-megaohm resistors, and closed switches are modeled as one-microohm resistors. All phase shifts are referenced to a 90 GHz test signal.

FIG. 6 shows a scatter plot 600 of simulations in which the series switches 250 are all kept open and the shunt switches 240 are varied between being open and closed. Each point on the plot 600 corresponds to a respective switch configuration, which results in an associated characteristic impedance from input 102 to output 104 and an associated phase shift from input 102 to output 104. It can be seen that varying only the shunt switches with all the series switches open causes characteristic impedance to vary between about 30 ohms and about 68 ohms (greater than a factor of 2), and causes phase shift to vary between -138 degrees and -96 degrees (greater than a factor of 1.4). The correlation is positive, with higher characteristic impedance associated with less negative phase shifts. Numerous outliers can be seen, however.

FIG. 7 shows a scatter plot 700 of simulations in which the shunt switches 240 are all closed and the series switches 250 are varied between being open and closed. Here, characteristic impedance varies between about 28 ohms and 43 ohms (greater than a factor of 1.5) and phase shift varies between -105 degrees and -140 degrees (greater than a factor of 1.3). The correlation between phase and characteristic impedance is negative.

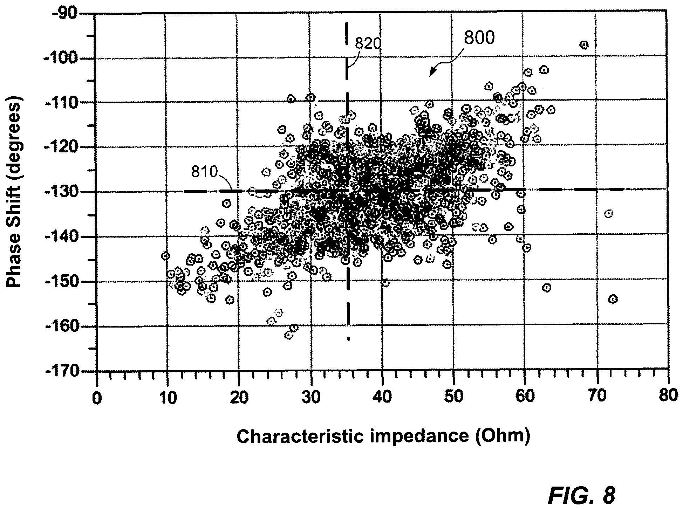

FIG. 8 shows a scatter plot 800 of simulations in which both the shunt switches 240 and the series switches 250 are varied between being open and closed. Here, the range of possibilities is greatly enlarged, with characteristic impedance varying between about 10 ohms and about 72 ohms (greater than a factor of 7) and phase shift varying between about -97 degrees and -163 degrees (nearly a factor of 1.7). FIG. 8 clearly demonstrates that the combination of shunt switches 240 and series switches 250 creates a large design space of possible values of characteristic impedance and phase shift, which is much greater than that which could be achieved with shunt switches alone or with series switches alone. Further, it should be emphasized that the plots 600, 700, and 800 are the results of sampling and thus are expected to understate the maximum ranges of variability that can be achieved.

It is clear from the plot 800 that characteristic impedance and phase shift can be varied independently of each other. For example, line 810 represents a particular phase shift (about -130 degrees) and intersects a large number of points, showing that the same phase shift can be achieved over a wide range of characteristic impedances. Likewise, line 820 represents a particular characteristic impedance (about 35 ohms) and intersects a large number of points, showing that the same characteristic impedance can be achieved over a wide range of phase shifts.

The results shown in FIGS. 6-8 assume ideal switches. Performance may be reduced somewhat when using actual switches, particularly at high frequencies. For example, simulations have been run at 90 GHz which assume switches having a 75-femtosecond FOM (figure of merit; e.g., R_{DS-ON} * C_{DS-OFF}) and 10-femtofarad off-capacitance. Such simulations still provide 45 degrees of phase tuning range and 35 ohms of characteristic-impedance tuning range. A reasonably large tuning range may be achieved at this frequency with FOM less than 100 femtosecond and with off-capacitance less than 20 femtofarads, although these values are by no means requirements. The quality of switches becomes less critical when operating at lower frequencies.

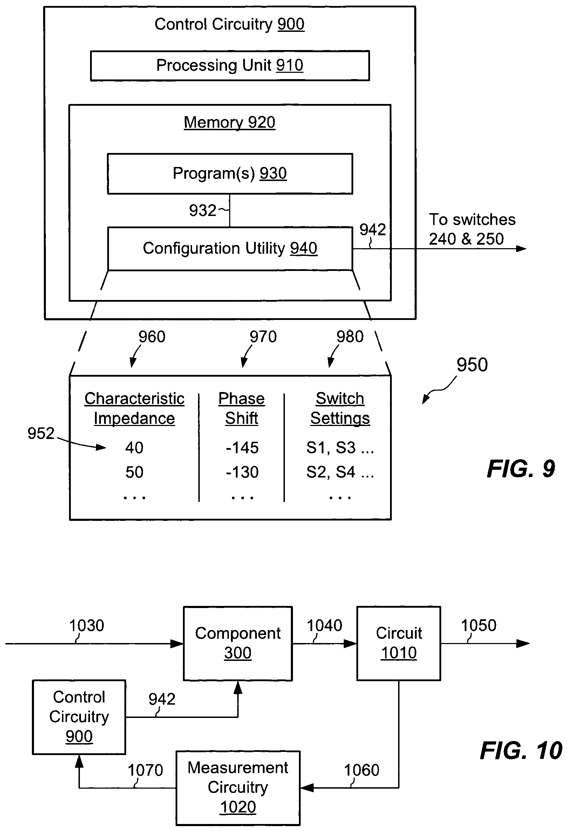

FIG. 9 shows example control circuitry 900 that may be provided in one or more embodiments for controlling the switches 240 and 250 of the component 300. The control circuitry 900 may be co-located with the component 300, e.g., in the same die, device, or assembly, or it may be disposed in a different die, device, or assembly. The control circuitry 900 may be dedicated for use with the component 300 (or multiple such components), or it may be arranged for more general-purpose use.

The control circuitry 900 includes a processing unit 910, such as a CPU (central processing unit) microcontroller, or other processor, and memory 920, which may include both volatile memory and non-volatile memory. The memory 920 stores one or more programs 930 and a configuration utility 940. The configuration utility 940 is constructed and arranged to identify switch settings (e.g., open or closed) for shunt switches 240 and series switches 250 of a component 300, based on desired values of characteristic impedance and phase shift, and to provide control signals 942 for establishing the identified switch settings in a component 300.

For example, the configuration utility 940 includes a data structure, such as a lookup table 950, which associates desired characteristic impedances 960 and associated phase shifts 970 with respective sets of switch settings 980 which, if configured in the component 300, would cause the component 300 to assume the desired characteristic impedances and phase shifts. The specified characteristic impedances 960 and phase shifts 970 may be determined based on actual measurements or simulations, for example.

Assume that one of the programs 930 issues a request 932 to configure the component 300. The request 932 identifies a desired characteristic impedance of 40 ohms and a desired phase shift of -145 degrees. In response to the request 932, the configuration utility 940 accesses the lookup table 950 and selects row 952, which specifies switch settings S1, S3, .... In this example, it is assumed that all switches 240 and 250 have unique identifiers. It is further assumed that all switches listed in the switch settings 980 are to be closed and that all switches not listed in the switch settings 980 are to be opened (merely by convention). The configuration utility 940 then configures the electronic component 300 according to the selected set of switch settings, e.g., by sending control signals 942 to the individual switches 940 and 950 (e.g., to the gates of FETs or the bases of BJTs) to open or close the switches based on the identified switch settings 980, e.g., S1, S3, ... in the above example. In some examples, switches 240 and 250 have controllable resistance rather than simply on and off states. In such examples, switch settings 980 may further specify the resistance (or a drive condition needed to achieve such resistance) of each switch that is to be at least partially turned on.

FIG. 10 shows a simplified arrangement of the component 300 for achieving or optimizing an electrical characteristic of a circuit 1010, according to one or more embodiments. Measurement circuitry 1020 is provided for measuring the electrical characteristic. The measurement circuitry 1020 may be separate from the circuit 1010 or may be part of the circuit 1010 itself. In this example, the component 300 receives an input signal 1030 at its input 102 (FIG. 1) and provides an output signal 1040 at its output 104. The input signal 1030 may be an RF or microwave signal, for example. The circuit 1010 receives the signal 1040 as input and produces its own output signal 1050. The circuit 1010 also produces a test signal 1060 that represents the electrical characteristic to be optimized. In some examples, the test signal 1060 is the same as the output signal 1050. The measurement circuitry 1020 measures the test signal 1060 and produces a measurement signal 1070, which is provided to the above-described control circuitry 900. Based on the measurement signal 1070, program 930 running on the control circuitry 900 then varies the switch settings of the component 300 to change the electrical characteristic, such as to optimize the electrical characteristic. For example, the program 930 may select switch settings corresponding to a different characteristic impedance and/or phase shift, which, once established in the component 300, brings the electrical characteristic as represented by the test signal 1060 closer to an optimal value.

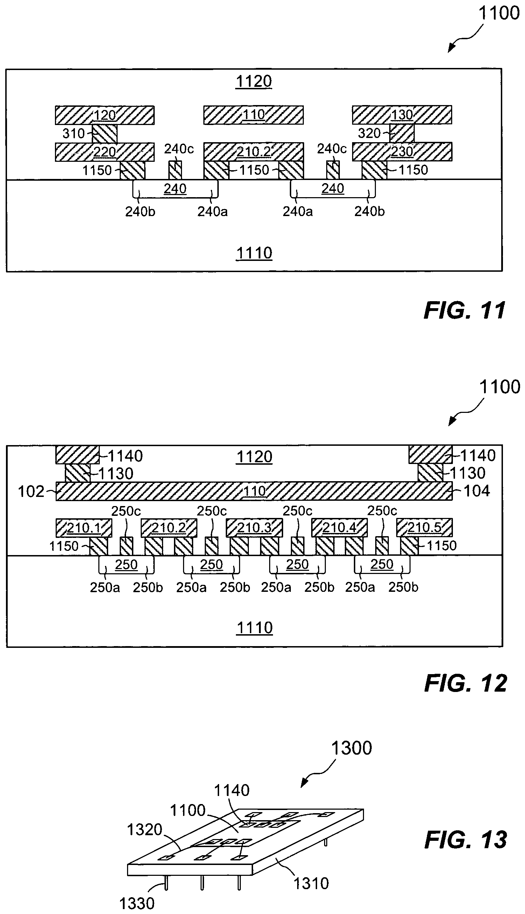

FIGS. 11 and 12 show an example semiconductor implementation of the component 300 according to one or more embodiments. FIG. 11 shows a cross-sectional view of an example semiconductor die 1100 taken along the line A-A of FIG. 3, and FIG. 12 shows a cross-sectional view of the same die 1100 taken along the line B-B of FIG. 3. Although the focus of FIGS. 11 and 12 is the component 300, one should appreciate that the die 1110 may include other circuits and components, which are omitted for the sake of simplicity.

As shown in FIG. 11, the semiconductor die 1100 includes a base semiconductor substrate 1110 and a build-up structure 1120. Shunt switches 240 (two shown) are formed within the substrate 1110, which may be composed of gallium arsenide, silicon, germanium, or the like. In the depicted example, switches 240 are provided as MOSFETs having sources 240a, drains 240b, and gates 240c. This is just an example, though, as other types of transistors, or other types of switches, may be used. Also, drain and source connections are not critical and their connections may be the opposite of those shown in the figure. Although no connections are shown to the gates 240c, one should appreciate that control signals 942 are routed to the gates 240c within the die 1100.

Traces 110, 120, 130, 220, and 230 and shield elements 210 are formed within patterned layers of the build-up structure 1120. For example, the build-up structure 1120 includes multiple metallization layers, with each metallization layer including a dielectric sublayer covered by a metal sublayer, such as aluminum, copper, nickel, chromium, gold, or the like. Vias may be provided to form electrical connections between metallization layers. For example, vertical conduction paths 310 and 320 may be formed using vias. Electrical connections between the substrate 1110 and the build-up structure 1120 may be made using contacts 1150, which themselves may be vias or other types of conductive paths, such as tungsten posts. Although the sectional view of FIG. 11 cuts through only one shield element 1410, one should appreciate that the same or a similar pattern may be repeated for other shield elements 210.

In FIG. 12, MOSFETs provide series switches 250 which connect adjacent shield elements 210. As above, drain and source connections are not critical and may be the opposite of those shown. Also, control signals 942 are routed to gates 250c within the die.

In the illustrated example, the input 102 and the output 104 of the component 300, i.e., the proximal and distal ends of the first (central) trace 110, are connected within the die 1100 to respective bond pads 1140 through respective vias 1130. The bond pads 1140 provide wiring access to the component 300 in situations in which such access is appropriate, such as where the component 300 is provided as a discrete component and where frequency considerations permit. In other situations, the bond pads 1140 may be omitted, e.g., where the input 102 and output 104 of the component 300 are connected only to other components within the die 1110. Also, in some examples bond pads may be provided for receiving control signals 942, e.g., in examples in which such control signals 942 are generated outside of the die 1100.

FIG. 13 shows an example device 1300 that incorporates the electronic component 300. The device 1300 includes the above-described die 1100 mounted within a package 1310. Bond pads 1140 of the die 1100 are connected to contacts 1330 using bonding wires 1320. Such bond pads 1140 may include signal bond pads, power bond pads, and ground bond pads, for example. The contacts 1130 may be pins, balls (for ball grid arrays), leads, or other types of electrical contacts. In some arrangements, bond pads 1140 may be provided on the substrate 1110 of the die 1100, in a so-called "flip-chip" arrangement. In such cases, the die 1100 may be mounted with the substrate 1110 facing up. Indeed, a flip-chip arrangement may be preferred at certain frequencies (e.g., tens of gigahertz and above), as it avoids the use of bond wires, which can impair signal integrity. In some examples, multiple dies may be included within a single package 1310, with connections formed between them. For example, the device 1300 may include a system substrate, such as a ceramic substrate or small printed circuit board, with connections formed between different dies and other components within the substrate, such as surface-mount components. A great deal of variety is possible, and the example shown in FIG. 13 is intended merely for illustration.

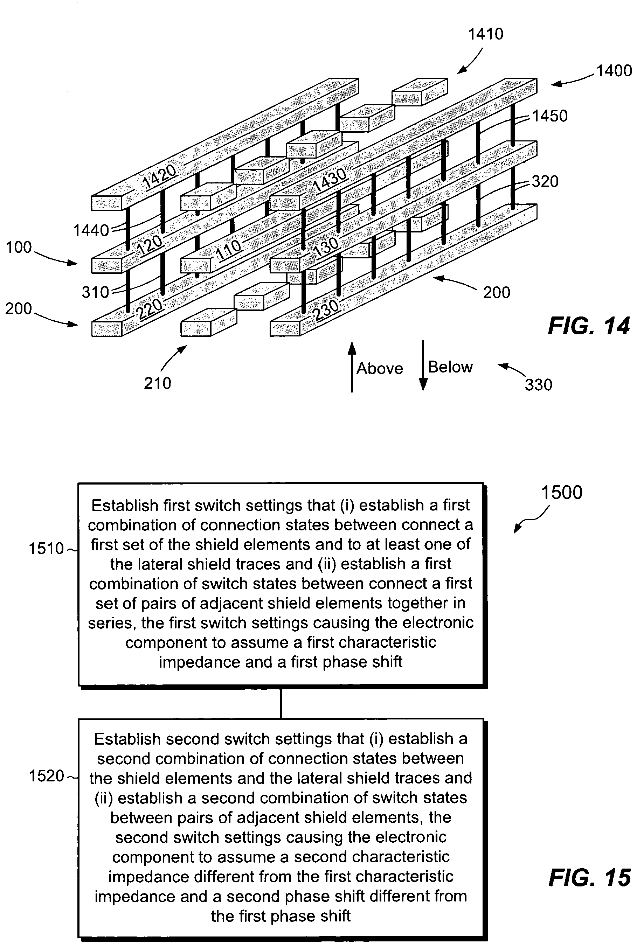

FIG. 14 shows an example embodiment of the component 300 having two shield structures. As shown, a second shield structure 1400 is disposed above the transmission structure 100 and opposite the shield structure 200, referred to now as the "first" shield structure. The second shield structure 1400 includes lateral traces 1420 and 1430, also referred to herein as a sixth conductive trace 1420 and a seventh conductive trace 1430, respectively, and multiple shield elements 1410, also referred to herein as "second" shield elements. Multiple vertical conduction paths 1440 electrically connect the second conductive trace 120 to the sixth conductive trace 1420, and multiple vertical conduction paths 1450 electrically connect the third conductive trace 130 to the seventh conductive trace 1430.

The second shield structure 1400 may be similar to the first shield structure 200 (as shown), or it may differ in various respects. For example, the second shield structure 1400 may include a different number of shield elements, a different spacing or offset of shield elements, and other variations, which promote even greater adjustability in terms of characteristic impedance and phase shift of the component 300. Further, the second shield structure 1410 may or may not include series switches and/or shunt switches.

FIG. 15 shows an example method 1500 that may be carried out in connection with the component 300 in accordance with one or more embodiments. The method 1500 is typically performed, for example, by the control circuitry 900 as shown in FIG. 9 acting upon the component 300. The various acts of method 1500 may be ordered in any suitable way.

At 1510, the control circuitry 900 establishes first switch settings 980 that (i) establish a first combination of connection states (e.g., with each connection state being open or closed) between the shield elements 210 and the lateral shield traces 220 and 230, e.g., via a first set of shunt switches 240, and (ii) establish a first combination of connection states between pairs of adjacent shield elements 210, e.g., via a first set of series switches 250. The first switch settings 980 cause the electronic component 300 to assume a first characteristic impedance and a first phase shift, such as those specified in a first row of the data structure 950.

At 1520, the control circuitry 900 establishes second switch settings 980 that (i) establish a second combination of connection states between the shield elements 210 and at least one of the lateral shield traces 220 and 230, e.g., via a second set of shunt switches 240, and (ii) establish a second combination of connection states between pairs of adjacent shield elements 210, e.g., via a second set of series switches 250. The second switch settings 980 cause the electronic component to assume a second characteristic impedance different from the first characteristic impedance and a second phase shift different from the first phase shift, such as those specified in a second row of the data structure 950.

According to one or more embodiments, the method 1500 further includes, after establishing the second switch settings 980, manufacturing a second electronic component which does not require the switches 240 and 250 but is otherwise similar to the electronic component 300 in construction. In the second electronic component, for example, all closed switches defined by the second switch settings are replaced with unswitchable conductive paths (e.g., shorts or resistors) and all open switches defined by the second switch settings are replaced with unswitchable nonconductive paths (e.g., opens). An optimal design for a particular circuit implementation thus can be determined using a fully-adjustable electronic component 300, and that optimal design can then be fixed in the second electronic component, which does not require the switches 240 or 250.

An improved technique has been described that provides an electronic component 300. The component 300 includes a transmission structure 100 and a shield structure 200 below the transmission structure 100. The transmission structure 100 includes a central trace 110 and a pair of lateral traces 120 and 130 that extend parallel to the central trace 110, with one lateral trace 120 or 130 on each side of the central trace 110. The shield structure 200 includes a pair of lateral traces 220 and 230 that extend below and parallel to the lateral traces 120 and 130 of the transmission structure 100, and multiple shield elements 210 that extend in a line 212 below the central trace 110 and between the lateral traces 220 and 230 of the shield structure 200. The component 300 further includes multiple shunt switches 240 configured to selectively connect one or more of the shield elements 210 to one or both lateral traces 220 and 230 of the shield structure 210. Advantageously, different configurations of the shunt switches 240 result in different characteristic impedances of the component 300 and different phase shifts through the component 300.

Certain embodiments are directed to an electronic component includes a transmission structure having a first conductive trace with a proximal end and a distal end, a second conductive trace spaced apart from and extending parallel to a first side of the first conductive trace, and a third conductive trace spaced apart from and extending parallel to a second side of the first conductive trace such that the first conductive trace extends between the second conductive trace and the third conductive trace. The electronic component further includes a shield structure disposed beneath the transmission structure. The shield structure includes a fourth conductive trace below and extending parallel to the second conductive trace, a fifth conductive trace below and extending parallel to the third conductive trace, and a plurality of conductive shield elements arranged in a line that extends below and parallel to the first conductive trace. The of conductive shield elements are spaced apart from one another and are disposed between the fourth conductive trace and the fifth conductive trace. The electronic component still further includes a plurality of shunt switches, including a first shunt switch arranged to selectively electrically connect a first shield element of the plurality of conductive shield elements to one of the fourth conductive trace and the fifth conductive trace.

According to one or more further embodiments, the second conductive trace is electrically connected to the fourth conductive trace via a first plurality of vertical conduction paths, and the third conductive trace is electrically connected to the fifth conductive trace via a second plurality of vertical conduction paths.

According to one or more further embodiments, the electronic component further includes a plurality of series switches that includes a first series switch arranged to selectively electrically connect together a pair of adjacent shield elements of the plurality of conductive shield elements.

According to one or more further embodiments, the plurality of shunt switches further includes a second shunt switch arranged to selectively electrically connect a second shield element of the plurality of conductive shield elements to one of the fourth conductive trace and the fifth conductive trace.

According to one or more further embodiments, the first shunt switch and the second shunt switch are individually controllable for opening and closing independently of each other.

According to one or more further embodiments, the first shunt switch is connected to one of the fourth conductive trace and the fifth conductive trace via a path having one of a first resistance and a second resistance, and the second shunt switch is connected to one of the fourth conductive trace and the fifth conductive trace via a path having the other of the first resistance and the second resistance. The first resistance is greater than the second resistance.

According to one or more further embodiments, the plurality of shunt switches further includes a set of additional shunt switches arranged to selectively electrically connect a set of additional shield elements of the plurality of conductive shield elements to at least one of the fourth conductive trace and the fifth conductive trace. The plurality of series switches includes multiple additional series switches arranged to selectively electrically connect together multiple adjacent pairs of shield elements, and the additional series switches are individually controllable.

According to one or more further embodiments, the electronic component further includes control circuitry constructed and arranged to establish multiple combinations of switch settings of the plurality of shunt switches and multiple combinations of switch settings of the plurality of series switches for establishing at least one of (i) adjustable characteristic impedance of the component and (ii) adjustable phase shift through the component.

According to one or more further embodiments, the control circuitry is further constructed and arranged to establish (i) multiple different characteristic impedances at a single phase shift and (ii) multiple different phase shifts at a single characteristic impedance.

According to one or more further embodiments, the transmission structure is formed in a first metallization layer of a semiconductor device, the shield structure is formed in at least a second metallization layer of the semiconductor device, and the plurality of shunt switches and the plurality of series switches are formed in a set of semiconductor layers of the semiconductor device.

According to one or more further embodiments, each of the plurality of shunt switches and each of the plurality of series switches includes a respective transistor having a figure of merit less than 100 femtoseconds and an off-capacitance less than 20 femtofarads.

According to one or more further embodiments, the transmission structure and the shield structure are formed within a substate, and the substrate further includes an input bond pad electrically connected to the proximal end of the first conductive trace and providing an input of the electronic component, an output bond pad electrically connected to the distal end of the first conductive trace and providing an output of the electronic component, and a set of ground bond pads electrically connected to one or more of the second, third, fourth and fifth conductive traces.

According to one or more further embodiments, the electronic component further includes a second shield structure disposed above the transmission structure. The second shield structure includes a sixth conductive trace above and extending parallel to the second conductive trace, a seventh conductive trace above and extending parallel to the third conductive trace, and a second plurality of conductive shield elements above the first conductive trace. The conductive shield elements of the second plurality of conductive shield elements are spaced apart from one another and arranged in a line that extends between the sixth conductive trace and the seventh conductive trace. The second shield structure further includes a plurality of second shunt switches, including a shunt switch arranged to selectively electrically connect a shield element of the second plurality of conductive shield elements to one of the sixth conductive trace and the seventh conductive trace.

Additional embodiments are directed to a semiconductor device including a die that includes a transmission structure formed in a metallization layer of the die. The transmission structure has a first conductive trace with a proximal end and a distal end, a second conductive trace spaced apart from and extending parallel to a first side of the first conductive trace, and a third conductive trace spaced apart from and extending parallel to a second side of the first conductive trace such that the first conductive trace extends between the second conductive trace and the third conductive trace. The die further includes a shield structure formed in at least one additional metallization layer of the die disposed beneath the first metallization layer. The shield structure includes a plurality of conductive shield elements spaced apart from one another and arranged in a line that extends below and parallel to the first conductive trace. The die still further includes a plurality of shunt switches, including a first shunt switch arranged to selectively electrically connect a first shield element of the plurality of conductive shield elements to at least one of the first conductive trace and the second conductive trace.

According to one or more further embodiments, the shield structure further includes a fourth conductive trace below and extending parallel to the second conductive trace and a fifth conductive trace below and extending parallel to the third conductive trace. The plurality of conductive shield elements are disposed between the fourth conductive trace and the fifth conductive trace, and the first shunt switch is arranged to selectively electrically connect the first shield element to the first conductive trace via the fourth conductive trace and via a set of vertical conduction paths between the first conductive trace and the fourth conductive trace.

According to one or more further embodiments, the die further includes a plurality of series switches that includes a first series switch arranged to selectively electrically connect together a pair of adjacent shield elements of the plurality of conductive shield elements.

Still further embodiments are directed to a method of operating an electronic component that includes a transmission structure and a shield structure below the transmission structure. The shield structure has a pair of lateral shield traces and multiple switchable shield elements that extend between the pair of lateral shield traces and below a central trace of the transmission structure. The method includes establishing first switch settings that (i) establish a first combination of connection states between the shield elements and the lateral shield traces and (ii) establish a first combination of switch states between pairs of adjacent shield elements. The first switch settings cause the electronic component to assume a first characteristic impedance and a first phase shift. The method further includes establishing second switch settings that (i) establish a second combination of connection states between the shield elements and the lateral shield traces and (ii) establish a second combination of switch states between pairs of adjacent shield elements. The second switch settings cause the electronic component to assume a second characteristic impedance different from the first characteristic impedance and a second phase shift different from the first phase shift.

According to one or more further embodiments, the method further includes accessing a data structure that associates multiple switch settings of the switchable shield elements with corresponding levels of characteristic impedance and phase shift. The method further includes identifying a desired characteristic impedance and a desired phase shift, selecting a set of switch settings that the data structure associates with the desired characteristic impedance and the desired phase shift, and configuring the electronic component according to the selected set of switch settings such that the electronic component assumes the desired characteristic impedance and provides the desired phase shift.

According to one or more further embodiments, the method further includes, after establishing the second switch settings, manufacturing a second electronic component in which one or more closed switches defined by the second switch settings are replaced with unswitchable conductive paths and one or more open switches defined by the second switch settings are replaced with unswitchable non-conductive paths.

Having described certain embodiments, numerous alternative embodiments or variations can be made. For example, the component 300 may be implemented in a variety of forms, such as discrete components, integrated circuits that contain other components, part of a module that contains multiple interconnected components, and the like. The component 300 may be included in wireless communication circuitry, such as circuitry implementing 5G or 6G technology, included in circuitry that processes radar signals, or included in other high-speed circuit applications.

Also, the shield structure 200 of the component 300 has been described above as including two lateral traces 220 and 230 (FIGS. 2 and 3). This is just an example, however. Alternatively, one or both lateral traces 220 and 230 may be omitted, and the contacts of the shunt switches 240 that would otherwise connect to the traces 220 and 230 may instead electrically connect to the lateral traces 120 and 130 (FIG. 3), e.g., using vias. Thus, a similar electrical effect can be achieved without the need for lateral traces 220 and 230.

Further, although features have been shown and described with reference to particular embodiments hereof, such features may be included and hereby are included in any of the disclosed embodiments and their variants. Thus, it is understood that features disclosed in connection with any embodiment are included in any other embodiment.

As used throughout this document, the words "*comprising*," "*including*," "*containing*," and "*having*" are intended to set forth certain items, steps, elements, or aspects of something in an open-ended fashion. Also, as used herein and unless a specific statement is made to the contrary, the word "*set*" means one or more of something. This is the case regardless of whether the phrase "*set of*" is followed by a singular or plural object and regardless of whether it is conjugated with a singular or plural verb. Also, a "*set of*" elements can describe fewer than all elements present. Thus, there may be additional elements of the same kind that are not part of the set. Further, ordinal expressions, such as "*first,*" "*second*," "*third*," and so on, may be used as adjectives herein for identification purposes. Unless specifically indicated, these ordinal expressions are not intended to imply any ordering or sequence. Thus, for example, a "*second*" event may take place before or after a "*first* event," or even if no first event ever occurs. In addition, an identification herein of a particular element, feature, or act as being a "*first*" such element, feature, or act should not be construed as requiring that there must also be a "*second*" or other such element, feature or act. Rather, the "*first*" item may be the only one. Also, and unless specifically stated to the contrary, "*based on*" is intended to be nonexclusive. Thus, "*based on*" should be interpreted as meaning "*based at least in part on*" unless specifically indicated otherwise. Further, although the term "*user*" as used herein may refer to a human being, the term is also intended to cover non-human entities, such as robots, bots, and other computer-implemented programs and technologies. Although certain embodiments are disclosed herein, it is understood that these are provided by way of example only and should not be construed as limiting.

The foregoing description refers to elements or nodes or features being "*connected*" or "*coupled*" together. As used herein, unless expressly stated otherwise, "*connected*" means that one element is directly joined to (or directly communicates with) another element, and not necessarily mechanically. Likewise, unless expressly stated otherwise, "*coupled*" means that one element is directly or indirectly joined to (or directly or indirectly communicates with, electrically or otherwise) another element, and not necessarily mechanically. Thus, although the schematics and component features shown in the figures depict one exemplary arrangement of elements, additional intervening elements, devices, features, or components may be present in one or more other embodiments of the depicted subject matter.

Those skilled in the art will therefore understand that various changes in form and detail may be made to the embodiments disclosed herein without departing from the scope of the following claims.

## Claims

1. An electronic component, comprising:
a transmission structure having a first conductive trace with a proximal end and a distal end, a second conductive trace spaced apart from and extending parallel to a first side of the first conductive trace, and a third conductive trace spaced apart from and extending parallel to a second side of the first conductive trace such that the first conductive trace extends between the second conductive trace and the third conductive trace;
a shield structure disposed beneath the transmission structure, the shield structure including a fourth conductive trace below and extending parallel to the second conductive trace, a fifth conductive trace below and extending parallel to the third conductive trace, and a plurality of conductive shield elements arranged in a line that extends below and parallel to the first conductive trace, wherein the plurality of conductive shield elements are spaced apart from one another and are disposed between the fourth conductive trace and the fifth conductive trace; and
a plurality of shunt switches, including a first shunt switch arranged to selectively electrically connect a first shield element of the plurality of conductive shield elements to one of the fourth conductive trace and the fifth conductive trace.

2. The electronic component of claim 1, wherein the second conductive trace is electrically connected to the fourth conductive trace via a first plurality of vertical conduction paths, and wherein the third conductive trace is electrically connected to the fifth conductive trace via a second plurality of vertical conduction paths.

3. The electronic component of claim 1 or 2, further comprising a plurality of series switches that includes a first series switch arranged to selectively electrically connect together a pair of adjacent shield elements of the plurality of conductive shield elements.

4. The electronic component of claim 3, wherein the plurality of shunt switches further includes a second shunt switch arranged to selectively electrically connect a second shield element of the plurality of conductive shield elements to one of the fourth conductive trace and the fifth conductive trace.

5. The electronic component of claim 4, wherein the first shunt switch and the second shunt switch are individually controllable for opening and closing independently of each other.

6. The electronic component of claim 5, wherein the first shunt switch is connected to one of the fourth conductive trace and the fifth conductive trace via a path having one of a first resistance and a second resistance, and wherein the second shunt switch is connected to one of the fourth conductive trace and the fifth conductive trace via a path having the other of the first resistance and the second resistance, the first resistance being greater than the second resistance.

7. The electronic component of claim 5 or 6, wherein the plurality of shunt switches further includes a set of additional shunt switches arranged to selectively electrically connect a set of additional shield elements of the plurality of conductive shield elements to at least one of the fourth conductive trace and the fifth conductive trace, wherein the plurality of series switches includes multiple additional series switches arranged to selectively electrically connect together multiple adjacent pairs of shield elements, and wherein the additional series switches are individually controllable.

8. The electronic component of any of claims 3 to 7, further comprising control circuitry constructed and arranged to establish multiple combinations of switch settings of the plurality of shunt switches and multiple combinations of switch settings of the plurality of series switches for establishing at least one of (i) adjustable characteristic impedance of the component and (ii) adjustable phase shift through the component.

9. The electronic component of claim 8, wherein the control circuitry is further constructed and arranged to establish (i) multiple different characteristic impedances at a single phase shift and (ii) multiple different phase shifts at a single characteristic impedance.

10. The electronic component of any of claims 3 to 9, wherein the transmission structure is formed in a first metallization layer of a semiconductor device, wherein the shield structure is formed in at least a second metallization layer of the semiconductor device, and wherein the plurality of shunt switches and the plurality of series switches are formed in a set of semiconductor layers of the semiconductor device.

11. The electronic component of claim 10, wherein each of the plurality of shunt switches and each of the plurality of series switches includes a respective transistor having a figure of merit less than 100 femtoseconds and an off-capacitance less than 20 femtofarads.

12. The electronic component of any of claims 3 to 11, wherein the transmission structure and the shield structure are formed within a substate, and wherein the substrate further includes:
an input bond pad electrically connected to the proximal end of the first conductive trace and providing an input of the electronic component;
an output bond pad electrically connected to the distal end of the first conductive trace and providing an output of the electronic component; and
a set of ground bond pads electrically connected to one or more of the second, third, fourth and fifth conductive traces.

13. The electronic component of any of claims 3 to 12, further comprising a second shield structure disposed above the transmission structure, the second shield structure including:
a sixth conductive trace above and extending parallel to the second conductive trace, a seventh conductive trace above and extending parallel to the third conductive trace, and a second plurality of conductive shield elements above the first conductive trace, the second plurality of conductive shield elements spaced apart from one another and arranged in a line that extends between the sixth conductive trace and the seventh conductive trace; and
a plurality of second shunt switches, including a shunt switch arranged to selectively electrically connect a shield element of the second plurality of conductive shield elements to one of the sixth conductive trace and the seventh conductive trace.

14. A method of operating an electronic component that includes a transmission structure and a shield structure below the transmission structure, the shield structure having a pair of lateral shield traces and multiple switchable shield elements that extend between the pair of lateral shield traces and below a central trace of the transmission structure, the method comprising:
establishing first switch settings that (i) establish a first combination of connection states between the shield elements and the lateral shield traces and (ii) establish a first combination of switch states between pairs of adjacent shield elements, the first switch settings causing the electronic component to assume a first characteristic impedance and a first phase shift; and
establishing second switch settings that (i) establish a second combination of connection states between the shield elements and the lateral shield traces and (ii) establish a second combination of switch states between pairs of adjacent shield elements, the second switch settings causing the electronic component to assume a second characteristic impedance different from the first characteristic impedance and a second phase shift different from the first phase shift.

15. The method of claim 14, further comprising:
accessing a data structure that associates multiple switch settings of the switchable shield elements with corresponding levels of characteristic impedance and phase shift;
identifying a desired characteristic impedance and a desired phase shift;
selecting a set of switch settings that the data structure associates with the desired characteristic impedance and the desired phase shift; and
configuring the electronic component according to the selected set of switch settings such that the electronic component assumes the desired characteristic impedance and provides the desired phase shift.

## Amended claims

### Amended claims in accordance with Rule 137(2) EPC.

1. An electronic component, comprising:
a transmission structure (100) having a first conductive trace (110) with a proximal end and a distal end, a second conductive trace (120) spaced apart from and extending parallel to a first side of the first conductive trace, and a third conductive trace (130) spaced apart from and extending parallel to a second side of the first conductive trace such that the first conductive trace extends between the second conductive trace and the third conductive trace;
a shield structure (200) disposed beneath the transmission structure, the shield structure including a fourth conductive trace (220) below and extending parallel to the second conductive trace, a fifth conductive trace (230) below and extending parallel to the third conductive trace, and a plurality of conductive shield elements (210) arranged in a line (212) that extends below and parallel to the first conductive trace, wherein the plurality of conductive shield elements are spaced apart from one another and are disposed between the fourth conductive trace and the fifth conductive trace; and
a plurality of shunt switches (240), including a first shunt switch arranged to selectively electrically connect a first shield element of the plurality of conductive shield elements to one of the fourth conductive trace and the fifth conductive trace; and
a plurality of series switches (250) that includes a first series switch arranged to selectively electrically connect together a pair of adjacent shield elements of the plurality of conductive shield elements.

2. The electronic component of claim 1, wherein the second conductive trace is electrically connected to the fourth conductive trace via a first plurality of vertical conduction paths (310), and wherein the third conductive trace is electrically connected to the fifth conductive trace via a second plurality of vertical conduction paths (320).

3. The electronic component of claim 1 or 2, wherein the plurality of shunt switches further includes a second shunt switch arranged to selectively electrically connect a second shield element of the plurality of conductive shield elements to one of the fourth conductive trace and the fifth conductive trace.

4. The electronic component of claim 3, wherein the first shunt switch and the second shunt switch are individually controllable for opening and closing independently of each other.

5. The electronic component of claim 4, wherein the first shunt switch is connected to one of the fourth conductive trace and the fifth conductive trace via a path having one of a first resistance and a second resistance, and wherein the second shunt switch is connected to one of the fourth conductive trace and the fifth conductive trace via a path having the other of the first resistance and the second resistance, the first resistance being greater than the second resistance.

6. The electronic component of claim 4 or 5, wherein the plurality of shunt switches further includes a set of additional shunt switches arranged to selectively electrically connect a set of additional shield elements of the plurality of conductive shield elements to at least one of the fourth conductive trace and the fifth conductive trace, wherein the plurality of series switches includes multiple additional series switches arranged to selectively electrically connect together multiple adjacent pairs of shield elements, and wherein the additional series switches are individually controllable.

7. The electronic component of any preceding claims 3, further comprising control circuitry constructed and arranged to establish multiple combinations of switch settings of the plurality of shunt switches and multiple combinations of switch settings of the plurality of series switches for establishing at least one of (i) adjustable characteristic impedance of the component and (ii) adjustable phase shift through the component.

8. The electronic component of claim 7, wherein the control circuitry is further constructed and arranged to establish (i) multiple different characteristic impedances at a single phase shift and (ii) multiple different phase shifts at a single characteristic impedance.

9. The electronic component of any preceding claim, wherein the transmission structure is formed in a first metallization layer of a semiconductor device, wherein the shield structure is formed in at least a second metallization layer of the semiconductor device, and wherein the plurality of shunt switches and the plurality of series switches are formed in a set of semiconductor layers of the semiconductor device.

10. The electronic component of claim 9, wherein each of the plurality of shunt switches and each of the plurality of series switches includes a respective transistor having a figure of merit less than 100 femtoseconds and an off-capacitance less than 20 femtofarads.

11. The electronic component of any preceding claim, wherein the transmission structure and the shield structure are formed within a substate, and wherein the substrate further includes:
an input bond pad electrically connected to the proximal end of the first conductive trace and providing an input of the electronic component;
an output bond pad electrically connected to the distal end of the first conductive trace and providing an output of the electronic component; and
a set of ground bond pads electrically connected to one or more of the second, third, fourth and fifth conductive traces.

12. The electronic component of any preceding claim, further comprising a second shield structure disposed above the transmission structure, the second shield structure including:
a sixth conductive trace above and extending parallel to the second conductive trace, a seventh conductive trace above and extending parallel to the third conductive trace, and a second plurality of conductive shield elements above the first conductive trace, the second plurality of conductive shield elements spaced apart from one another and arranged in a line that extends between the sixth conductive trace and the seventh conductive trace; and
a plurality of second shunt switches, including a shunt switch arranged to selectively electrically connect a shield element of the second plurality of conductive shield elements to one of the sixth conductive trace and the seventh conductive trace.

13. A method of operating an electronic component that includes a transmission structure (100) and a shield structure (200) below the transmission structure, the shield structure having a pair of lateral shield traces (220, 230) and multiple switchable shield elements (210) that extend between the pair of lateral shield traces and below a central trace of the transmission structure, the method comprising:
establishing first switch settings that separately (i) establish a first combination of connection states between the shield elements and the lateral shield traces and (ii) establish a first combination of switch states between pairs of adjacent shield elements, the first switch settings causing the electronic component to assume a first characteristic impedance and a first phase shift; and
establishing second switch settings that (i) establish a second combination of connection states between the shield elements and the lateral shield traces and (ii) establish a second combination of switch states between pairs of adjacent shield elements, the second switch settings causing the electronic component to assume a second characteristic impedance different from the first characteristic impedance and a second phase shift different from the first phase shift.

14. The method of claim 13, further comprising:
accessing a data structure that associates multiple switch settings of the switchable shield elements with corresponding levels of characteristic impedance and phase shift;
identifying a desired characteristic impedance and a desired phase shift;
selecting a set of switch settings that the data structure associates with the desired characteristic impedance and the desired phase shift; and
configuring the electronic component according to the selected set of switch settings such that the electronic component assumes the desired characteristic impedance and provides the desired phase shift.
